(19)

**Europäisches Patentamt**

**European Patent Office**

**Office européen des brevets**

(11) **EP 4 431 644 A1**

(12) **EUROPEAN PATENT APPLICATION**

(43) Date of publication:
**18.09.2024  Bulletin 2024/38**

(51) International Patent Classification (IPC):
***C30B 23/06*** (2006.01)      ***C30B 29/36*** (2006.01)

(21) Application number: **23161965.1**

(52) Cooperative Patent Classification (CPC):
**C30B 29/36; C30B 23/066**

(22) Date of filing: **15.03.2023**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **SiCrystal GmbH**
**90411 Nürnberg (DE)**

(72) Inventors:
• **Müller, Ralf**
**90411 Nürnberg (DE)**

• **Ecker, Bernhard**
**90411 Nürnberg (DE)**
• **Schuh, Philipp**
**90411 Nürnberg (DE)**
• **Stockmeier, Matthias**
**90411 Nürnberg (DE)**
• **Vogel, Michael**
**90411 Nürnberg (DE)**

(74) Representative: **Grünecker Patent- und Rechtsanwälte**
**PartG mbB**
**Leopoldstraße 4**
**80802 München (DE)**

(54) **SUBLIMATION SYSTEM AND METHOD OF GROWING AT LEAST ONE SINGLE CRYSTAL OF A SEMICONDUCTOR MATERIAL**

(57)    The present invention relates to systems and methods for growing bulk semiconductor single crystals, and more specifically, for growing bulk semiconductor single crystals, such as silicon carbide, based on physical vapor transport. The sublimation system comprises a crucible (202) having a longitudinal axis (212) and a sidewall (218) extending along the longitudinal axis (212), wherein the crucible (202) comprises a fixing means for at least one seed crystal (210) and at least one source material compartment (204) for containing a source material (208); and a heating system for generating a temperature field around a circumference of the crucible (202) along the longitudinal axis (212) of the crucible (202); a thermally insulating unit (214) arranged within the source material compartment (204) at the sidewall (218) of the crucible (202).

Fig. 2

EP 4 431 644 A1

**Description**

The present invention relates to systems and methods for growing bulk semiconductor single crystals, and more specifically, for growing bulk semiconductor single crystals, such as silicon carbide, based on physical vapor transport.

Silicon carbide (SiC) is extensively used as a semiconductor substrate material for electronic components in a wide range of applications, such as power electronics, radio frequency, and light emitting semiconductor components.

Physical vapor transport (PVT) is generally used for growing bulk SiC single crystals, and in particular, for commercial purposes. The SiC substrates are produced by cutting slices from the bulk SiC crystal (for e.g. using wire saws) and finishing the slice surface with a sequence of polishing steps. The finished SiC substrates are employed in the manufacturing of semiconductor components, such as in epitaxial processes where thin monocrystalline layers of a suitable semiconductor material (e.g., SiC, GaN) are deposited onto the SiC substrate. The characteristics of the deposited monolayers and the components produced therefrom depend crucially on the quality and homogeneity of the underlying substrate. For this reason, the outstanding physical, chemical, electrical and optical properties of SiC make it a preferred semiconductor substrate material for power device applications.

PVT is a crystal growing method that essentially involves sublimation of a suitable source material followed by re-condensation at a seed crystal, where the formation of the single crystal takes place. The source material and seed crystal are placed inside a growth structure, where the source material is sublimed by heating. The sublimed vapor then diffuses in a controlled manner due to a temperature field having a gradient established between source material and seed crystal and deposits onto the seed to grow as a single crystal.

Conventional PVT-based growth systems generally employ either inductive or resistive heating systems for subliming the source material. In both cases, the core of the PVT-based growth system is the so-called reactor. The growth structure, essentially comprising a crucible and a fixing means for the seed crystal and conventionally made of graphite and carbon materials, is placed in the interior of the reactor and heated by either induction coils arranged outside the reactor or by resistive heaters arranged outside or inside the reactor. The temperature within the growth structure is measured by one or more pyrometers or by one or more thermocouples installed close to an overture of the growth structure. The vacuum-sealed reactor is evacuated by one or more vacuum pumps and supplied with inert or doping gases via one or more gas feeds to create a controlled gas (gas mixture atmosphere). All process parameters (pressure, temperature, gas flow, etc.) can be adjusted, controlled and stored by a computer-operated system controller, which communicates with all involved components (for e.g. inverter, pyrometer, vacuum control valve, mass flow control (MFC), and pressure gauges).

In the case of inductively-heated PVT systems, the reactor usually includes one or more glass tubes, which are optionally cooled with water and provided at both ends with flanges to seal the interior of the reactor against the atmosphere. An example of such an inductively heated PVT system is described in patent US 8,865,324 B2. Fig. 13 illustrates such a conventional inductively heated PVT system 1300.

The growth arrangement 1300 comprises a growing crucible 1302, which contains an SiC supply region 1304 and a crystal growth region 1306. Powdery SiC source material 1308, which is poured as a pre-finished starting material before the beginning of the growth process into the SiC supply region 1304 of the growing crucible 1302, for example, is located in the SiC supply region 1304. The source material 1308 may also be densified or may at least partly consist of solid material in order to enhance the density of the source material 1308.

A seed crystal 1310 is provided on an inner wall opposing the SiC supply region 1304 of the growing crucible 1302, e. g. on its crucible lid 1312, in the crystal growth region 1306. The bulk SiC single crystal to be grown grows on the seed crystal 1310 by deposition from an SiC growth gas phase forming in the crystal growth region 1306. The growing bulk SiC single crystal and the seed crystal 1310 may have approximately the same diameter.

The growing crucible 1302 including the crucible lid 1312 may be fabricated from an electrically and thermally conductive graphite crucible material. Around it is arranged a thermal insulation (not shown in the Figure), which may comprise, for example, a foam-like graphite insulation material, the porosity of which is, in particular, higher than that of the graphite crucible material.

The thermally insulated growing crucible 1302 is placed inside a tubular container 1314, which may be configured as a quartz glass tube and forms an autoclave or reactor. An inductive heating device in the form of a heating coil 1316 is arranged around the container 1314 to heat the growing crucible 1302. The growing crucible 1302 is heated by the heating coil 1316 to growth temperatures of more than 2000 °C, in particular to about 2200 °C. The heating coil 1316 inductively couples an electric current into an electrically conductive crucible wall (the so-called susceptor) of the growing crucible 1302. This electric current flows substantially as a circulating current in the peripheral direction within the circular and hollow cylindrical crucible wall and in the process heat the growing crucible 1302. The susceptor can be made from graphite, TaC, WC, Ta, W, or other refractory metals. The primary purpose of the susceptor is to provide a heat source for the inside of the crucible 1302. When the susceptor is heated with induction, the surface of the susceptor reaches a high temperature, and the temperature is then transferred to the inside of the crucible 1302 through conduction and/or radiation.

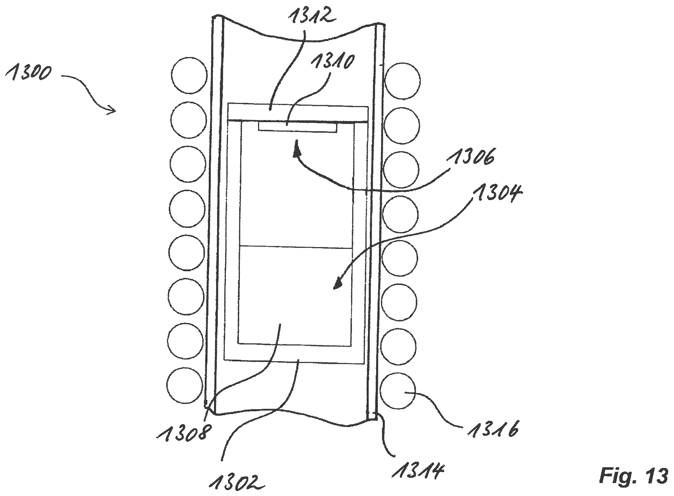

As mentioned above, the induction coil 1316 is mounted outside the glass tube 1314 and is usually surrounded by a Faraday cage (not visible in the drawing) forming an electromagnetic shielding to shield the electromagnetic radiation. As shown in the example of Fig. 13, the induction coil 1316 may be wound with equidistant windings.

Furthermore, in conventional resistively-heated PVT systems, the heating resistive elements are mounted inside the reactor. In case the reactor is made of metal, refractory metal and/or graphite, it can be cooled by water or air. Examples of resistively-heated PVT systems are described in published patent applications US 2016/0138185 A1and US 2017/0321345 A1.

For the growth of a high-quality crystal, a homogeneous coupling of the heat into the growth crucible in the radial direction is considered as being of enormous importance. By coupling the heat as homogeneously as possible, the crystal should also grow as homogeneously and symmetrically as possible. Among other things, this should prevent the formation of threading screw dislocations (TSD) and threading edge dislocations (TED), also called step dislocations, whose formation is favored by an inhomogeneous, asymmetrical heat distribution and the associated inhomogeneous, asymmetrical growth.

Consequently, PVT growth systems have to heat up the inside of the crucible with a temperature field that is as homogeneous as possible in a radial direction and providing a defined temperature-gradient in an axial direction, in order to set a driving force for the sublimed gas species moving to the seed and the growing single-crystal. In known PVT systems, the reactor structures, which are usually made of graphite or a comparable material, are heated from the wall region, creating a temperature gradient from the exterior to the interior of the crucible. As a result, the conversion of the SiC source decreases from the outside to the inside.

Thereby, a region is created in the source compartment where the temperature is no longer sufficient for a complete conversion and only recrystallization of source material occurs, which thus no longer contributes anything to crystal growth. This effect is enhanced by the transformation of the sintered SiC powder into a carbon sponge, caused by the different partial pressures of silicon and carbon-rich gas species. The carbon sponge reduces its thermal conductivity with increasing growth time and increasingly acts as an insulator between the heater and the source material. To counteract this effect, the source material must be heated more strongly for further growth. Nevertheless, a residue of unreacted material often remains. Unreacted or thermally insulated source material thus leads to a greatly reduced yield and thus to increased costs.

With increasing crystal diameter, a successive increase in the reactor size and the introduced crucible is also necessary. Due to the effects described above, the effective usability of the introduced source material is further reduced because of the increasing diameter of the reactor.

Due to the different partial pressures of the gas species containing Si and C, the chemical composition of the source material contributing to crystal growth changes. If the processes described above mean that fresh material is no longer available for crystal growth, the chemical composition of the gas phase also changes, which has an influence on crystal growth and thus leads to losses in crystal quality.

The reduction of the thermal conductivity or the graphitization of the source material is inevitable in the PVT process as it is used for the economic production of SiC single crystals in order to produce crystals with high diameters or corresponding lengths. A reduction of the negative effect of the non-conversion of the SiC containing source can be achieved for example by the introduction of a local heating element.

For instance, from the Chinese utility model CN210974929U, it is known to insert a solid rod inside the source reservoir for this purpose.

The insertion of this local heating element is intended to prevent recrystallization of the source material at the lower end of the crucible bottom, as well as to increase the thermal conduction towards the center of the source reservoir. As a result, a larger volume is homogeneously heated and graphitization of the source is locally reduced. In this document, the heating of the crucible is made possible by an induction coil. The hottest point is thus at the outer edge of the crucible and the rod inside the reservoir serves as an extension of the heating element by means of thermal conduction, by transporting the heat axially and radially from the wall of the crucible to the center of the powder reservoir.

The shape of such an additional conduction heater can also vary, as shown in the Japanese patent specification JP6859800B2. The geometrical variations shown in this document correspond to the same principle as in the Chinese utility model CN210974929U. According to JP6859800B2, a cylinder open on one side with a recess at the lower end located at least in the centric part of the bottom is proposed. In addition, a complementary conical component is introduced into this recess.

According to the patent specification JP6859800B2, only the outer cylinder walls are heated via induction or resistance heating, and the heat is conducted into the powder volume via the additional conical component.

Another advantage of such a setup is the possibility of removing the recrystallized source material at the bottom of the crucible, thus increasing the lifetime of the crucible material.

Another known approach to optimize the reaction of the source material is described in the Japanese patent JP6501494B2. Here, a combination of two additional disc shaped components (a heat generating member and a heating auxiliary portion) is placed underneath the structure filled with source material. Because the diameter of the heat generating member is significantly smaller than that of the heating auxiliary portion, the resulting diameter difference is compensated by installing a heat insulating material. Due to the increased diameter of the heat generating member, the induction coil can couple more efficiently and thus heats up more than the auxiliary heating member and the crucible. Due to the thermal conduction, the heat generating member thus acts as a resistance heater, transporting the temperature locally to the center and thus reducing or even preventing recrystallization of the source material.

However, there is still a need for a system for growing single crystals of a semiconductor material by physical vapor transport (PVT) and a method of manufacturing same with improved single crystal quality and in a cost effective manner, utilizing the employed source material more efficiently.

This object is solved by the subject matter of the independent claims. Advantageous embodiments of the present invention are subject matter of the dependent claims.

The present disclosure is based on the idea that thermally insulating some areas of the sidewall of the crucible from the source material container leads to a more homogenous temperature distribution in radial direction within the crucible.

Temperature differences along the longitudinal axis of a crucible are desirable. However, in radial direction the temperature should be homogenous. However, in a conventional sublimation system without insulating unit the isotherms that extend across the longitudinal axis exhibit a strong bent. This illustrates that the temperature also varies in radial direction, which as discussed above is an undesirable effect. If a thermally insulating unit is present inside the source material compartment adjacent to the sidewall of the crucible, these isotherms are less bent and thus the undesirable temperature inhomogeneity can be alleviated.

The more homogenous temperature distribution makes it possible to more efficiently use the available source material during the growth process. Another significant advantage is that the gas phase composition can be kept constant for a longer time span over the growth process.

A resulting advantage is a significant increase in the effectively usable mass of source material for the growth of the crystal and thus a possible increase in length as well as quality of the grown single crystal.

These advantages may specifically well be reached for growing SiC single crystals. However, it is clear that also the sublimation growth of other semiconductor crystals may benefit from the principles according to the present disclosure.

In particular, a sublimation system is provided, which comprises a crucible having a longitudinal axis and a sidewall extending along the longitudinal axis, wherein the crucible comprises a fixing means for at least one seed crystal and at least one source material compartment for containing a source material; and a heating system for generating a temperature field around a circumference of the crucible along the longitudinal axis of the crucible. A thermally insulating unit is arranged within the source material compartment at the sidewall of the crucible.

According to an advantageous example, the thermally insulating unit is arranged adjacent to an area in which during operation the temperature is higher than at the remaining part of the sidewalls of the source material compartment. Such an arrangement leads to a uniform temperature distribution in radial direction of the crucible.

The system may also comprise an outer insulation unit. Such a unit reduces the heat flow to the environment of the crucible and, thus, reduces the energy consumption.

Furthermore, the system may comprise at least one pillar arranged in the source material compartment along the longitudinal axis. This barrier conducts heat to the center part of the source material compartment. Thus, increasing the homogeneity of the temperature distribution in radial direction.

In another advantageous example, the source material compartment is divided into two separate compartments by a barrier, which extends across the longitudinal axis and the crucible comprises a fixing means for at least two seed crystals. The advantage of such a system is that two crystal growing regions are supplied simultaneously. This allows for an accelerated manufacturing process and an optimized utilization of space and energy.

In the system of the previous example, the heating system may be arranged so that during operation the temperature at the barrier extending across the longitudinal axis is higher than at the remaining part of the sidewalls of the source material compartment. Such a system has the advantage that the heat generated by the heating system heats both compartments of the divided source material compartment about equally, thus reducing the overall energy consumption.

The thermal conductivity of the thermally insulating unit may be lower than the thermal conductivity of the source material and/or the thermal conductivity of a material of the sidewalls. Consequently, the thermally insulating unit conducts heat at a lower rate than the source material and/or the material of the sidewalls. The thermal flow over the path sidewall-insulating unit-source material is therefore smaller than that over the path sidewall-source material. This leads to a more homogenous distribution of heat in the radial direction of the crucible.

In a further advantageous example, the porosity of the thermally insulating unit is higher than the porosity of the source material and/or the porosity of the material of the outer insulating unit. Such a configuration has the advantage that the both the thermal conduction and the thermal radiation are influenced in such a way as to allow for a homogenous distribution of heat in the radial direction of the crucible.

Moreover, the volume of the thermally insulating unit may be between 10% and 35% of the volume of the crucible, preferably the volume of the thermally insulating unit may be 35% of the volume of the crucible. The advantage of such a configuration is that the distribution of heat in the radial direction of the crucible may be more homogenous.

In another advantageous example, the heat conductivity of the thermally insulating unit may be at least 20% smaller than the thermal conductivity of a material of the crucible. Choosing such a material for the thermally insulating unit, leads to a more homogenous distribution of heat in the radial direction of the crucible.

In a further advantageous example, the porosity of the thermally insulating unit may be between 50% and 90% of the porosity of the graphite used to construct the crucible; preferably, the porosity of the thermally insulating unit may be 70% of the porosity of the graphite used to construct the crucible. Such a configuration has the advantage that both the thermal conduction and the thermal radiation are influenced in such a way as to allow for a homogenous distribution of heat in the radial direction of the crucible.

Moreover, the thermally insulating unit may comprise at least one of porous graphite, graphite felt and graphite powder. These materials were shown to enhance the homogenous heat distribution in the radial direction of the crucible, while at the same time not negatively affecting the source material. If the thermally insulating unit is formed from the same material as the sidewall of the crucible, the thermally insulating unit can be formed integrally with the crucible, thus facilitating the fabrication of the sublimation system.

In another advantageous example, the thermally insulating unit may form a ring along the sidewall of the crucible. Thus, it is possible for the thermally insulating unit to be adjacent to all areas of the sidewalls that are hotter than the surrounding areas of the sidewall. This arrangement allows for a more homogenous distribution of heat in the radial direction of the crucible.

In a further advantageous example, an inner wall of the thermally insulating unit may form a funnel shape or a concave cylinder. Both forms lead to a particularly homogenous distribution of heat in the radial direction of the crucible.

The present disclosure further relates to a method of growing at least one single crystal of a semiconductor material by means of a sublimation growing process, the method comprising:

providing a crucible having a longitudinal axis and a sidewall extending along the longitudinal axis, fixing at least one seed crystal at a fixing means of the crucible, and filling a source material into at least one source material compartment;

wherein, during at least a part of the growing process, a thermally insulating unit is present within the source material compartment at the sidewall of the crucible;

generating, by means of a heating system, a temperature field around a circumference of the crucible and along the longitudinal axis of the crucible.

As mentioned above, thermally insulating some areas of the sidewall of the crucible from the source material container leads to a more homogenous temperature distribution in radial direction within the crucible. If a thermally insulating unit is present inside the source material compartment adjacent to the sidewall of the crucible, the isotherms during the growing process are less bent and thus the undesirable temperature inhomogeneity can be alleviated. This effect may be achieved by either providing an inserted thermally insulating unit before starting the growing process, or by using a temperature profile during the growth of the single crystal, which causes the formation of a suitably formed graphite foam on the inside of the crucible sidewall.

The resulting more homogenous temperature distribution makes it possible to more efficiently use the available source material during the growth process. Another significant advantage is that the gas phase composition can be kept constant for a longer time span over the growth process.

A resulting advantage is a significant increase in the effectively usable mass of source material for the growth of the crystal and thus a possible increase in length as well as quality of the grown single crystal.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:

**FIG. 1**     is a schematic sectional side view of a sublimation system according to the state of the art;

**FIG. 2**     is a schematic sectional side view of a sublimation system according to a first example;

**FIG. 3**     is a schematic sectional top view of a sublimation system according to the state of the art;

**FIG. 4**     is a schematic sectional top view of a sublimation system according to a first example;

**FIG. 5**     is a schematic sectional side view of a sublimation system according to a further example;

**FIG. 6**     is a schematic sectional side view of a sublimation system according to a further example;

**FIG. 7**     is a schematic sectional side view of a sublimation system according to a further example;

**FIG. 8**     is a schematic sectional side view of a sublimation system according to a further example;

**FIG. 9**     is a schematic sectional side view of a sublimation system according to a further example;

**FIG. 10**     is a schematic sectional side view of a sublimation system according to a further example;

**FIG. 11**     is a schematic sectional side view of a sublimation system according to a further example;

**Fig. 12**     is a schematic sectional side view of a sublimation system according to a further example;

**Fig. 13**     is a schematic sectional side view of a known sublimation system.

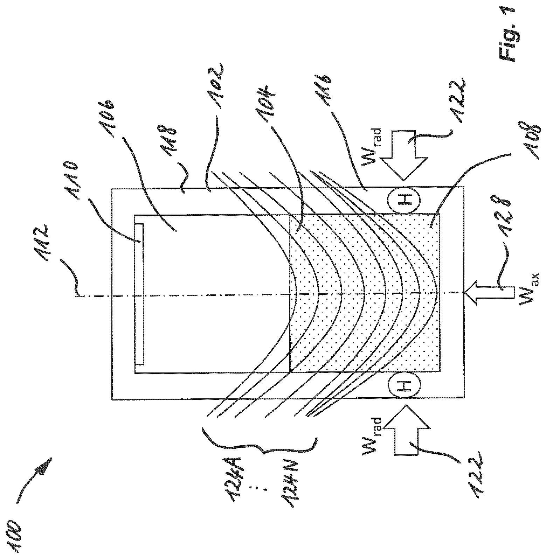

The present invention will now be explained in more detail with reference to the Figures and firstly referring to Figures 1 to 4.

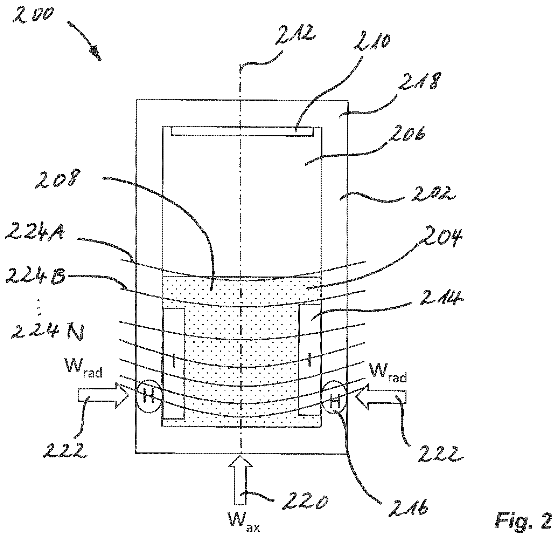

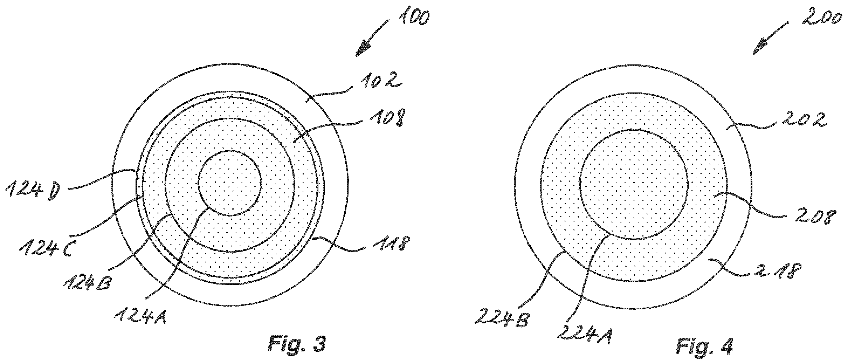

For better understanding the effects of the present disclosure, Fig. 1 and 3 show a sublimation system 100 according to the state of the art. This system does not comprise a thermally insulating unit as will be described in connection with Fig. 2 and 4. It should be noted that the term sublimation system is intended to cover any system for growing at least one single crystal of a semiconductor material by means of a sublimation growing process. Preferably, the term refers to a physical vapor transport (PVT) system for growing silicon carbide (SiC) volume single crystals as described with reference to Fig. 13. Moreover, the heating system is not depicted in Fig. 1 to 12 as its specific structure is not relevant for the gist of present disclosure.

The known sublimation system comprises a growing crucible 102, which contains a source material compartment, in particular an SiC supply region 104 and a crystal growth region 106. Powdery SiC source material 108, which is poured as a pre-finished starting material before the beginning of the growth process into the SiC supply region 104 of the growing crucible 102, for example is located in the SiC supply region 104. The source material 108 may be densified or at least partly consist of solid material to enhance the density of the source material 108.

A seed crystal 110 is provided on an inner wall opposing the SiC supply region 104 of the growing crucible 102, for instance on the top section of the crucible, in the crystal growth region 106. The bulk SiC single crystal to be grown grows on the seed crystal 110 by deposition form an SiC growth gas phase forming in the crystal growth region 106. The growing bulk SiC single crystal and the seed crystal 110 may have approximately the same diameter. The bulk SiC single crystal may also have a larger diameter than the seed crystal 110, if the diameter of the crystal channel is larger than the seed crystal 110. However, the usable low-defect diameter of the grown bulk SiC single crystal usually is the same size as the diameter of the seed crystal 110.

The growing crucible 102 may be fabricated from an electrically and thermally conductive graphite crucible material. It is surrounded by a thermal insulation (not shown in the Figure), which may comprise, for example, a foam-like graphite insulation material, the porosity of which is higher than that of the graphite crucible material. In the following this thermal insulation is referred to as outer insulation unit.

In case of an inductive heating, the thermally insulated growing crucible 102 is placed inside a tubular container (not shown in Fig. 1), which may be configured as a quartz glass tube and forms an autoclave or reactor. An inductive heating device in the form of a heating coil (not shown in the Figure) is arranged around the container to heat the growing crucible 102. The heating coil generates the required temperature field by inductively coupling an electric current into an electrically conductive crucible wall (the susceptor) of the growing crucible 102. This electric current flows substantially as a circulating current in the peripheral direction within the circular and hollow cylindrical crucible wall and in the process heat the growing crucible 102. The susceptor can be made from graphite, TaC, WC, Ta, W, or other refractory metals, and may either be an integral part of the crucible 102 or may be a separate part close to the crucible wall. The primary purpose of the susceptor is to provide a heat source for inside of the crucible 102. When the susceptor is heated with induction, the surface of the susceptor reaches a high temperature, and the temperature is then transferred to the inside of the crucible 102 through conduction and/or radiation.

As mentioned above, the coil is mounted outside the glass tube in case of an inductive heating and is usually surrounded by a Faraday cage (not visible in Fig. 1) to shield the electromagnetic radiation. In case of a resistive heating, the coil is mounted within the reactor and also within the thermal insulation, thus being in close contact to the crucible 102. The principles of the present disclosure are applicable to both heating techniques. Thus, the coil will more generally be referred to as a heating means and encompasses inductive as well as resistive heating (or a combination thereof) in the following.

The temperature field created inside the crucible 102 is symmetrical radially around the central axis 120 and has a gradient driving the growth of the single crystal in a direction along the central axis 120.

The heating system leads to areas with higher temperature 116 within the sidewall of the crucible 118. These areas 116 are characterized in that their temperature is higher than that of the surrounding area of the sidewall 118.

Fig. 1 further shows the axial heat flow 120 and the radial heat flow 122. Due to the thermal conductivity of the source material 108 and the geometry of the crucible, the radial heat flow is significantly larger than the axial heat flow:

$$W_{rad} \gg W_{ax}$$

This leads to significantly bent isotherms 124 A-N. These strongly bent isotherms 124 A-N indicate an inhomogeneous temperature distribution in radial direction of the crucible. Isotherms parallel to the base of the crucible would indicate a completely homogenous temperature distribution. Fig 3 shows a top view of the system 100. The isotherms 124 A, B, C, D symbolize that several distinct temperature levels exist in the source material, thus, indicating an inhomogeneous temperature distribution in radial direction.

In comparison to this known growth system, Fig. 2 illustrates the sublimation system 200 according to the present invention. The system 200 differs from the system 100 of Fig. 100 in that it additionally comprises at least one thermally insulating unit. The thermally insulating unit 214 is arranged within the source material compartment 204 immediately adjacent to the sidewall of the crucible 218. In accordance with one embodiment of the present invention the thermally insulating unit 214 may be arranged adjacent to the areas with high temperature 216 within the sidewall of the crucible 218.

It should be noted that all other features of the system of Fig. 2 are identical with those described with reference to Fig. 1 and will not be explained again for the sake of brevity.

The thermally insulating unit 214 may form a ring along the sidewall of the crucible 218.

Fig. 2 further shows the axial heat flow 220 and the radial heat flow 222. As symbolized by the size of the arrows $W_{rad}$ in Fig. 1 and Fig. 2 radial heat flow in Fig. 2 (with thermally insulating unit 214) is reduced compared to the known arrangement of Fig. 2. Consequently, the difference between radial heat flow and axial heat flow is reduced in system 200. This leads to isotherms 224 A-N are less bent than the isotherms 124 A-N illustrated in Fig. 2. As pointed out above, this indicates a more homogenous temperature distribution in radial direction within the crucible 202.

Fig. 4 shows a top view of the system 200, which includes the thermally insulating unit 214. The isotherms 224 A, B indicate that fewer distinct temperature level exist in the source material 208, than in system 100 (shown in Fig. 3).

The thermally insulating unit 214 may comprise a material that has a lower thermal conductivity than the source material 208. Additionally or alternatively, the material of the thermally insulating unit 214 may have a lower thermal conductivity than the material of the sidewall of the crucible 218.

Furthermore, the material of the thermally insulating unit 214 may have a higher porosity than the source material 208. Additionally or alternatively, the material of the thermally insulating unit 214 may have a higher porosity than the material of the outer insulation unit (not shown in Fig. 2).

Moreover, the volume of the thermally insulating unit 214 may be between 10% and 50% of the volume of the crucible 202. Preferably, the volume of the thermally insulating unit 214 may be 35% of the volume of the crucible.

Additionally, the thermal conductivity of the thermally insulating unit 214 may be at least 20% smaller than the thermal conductivity of the material of the crucible.

In addition, the porosity of the material of the thermally insulating unit 214 is between 50% and 90% of the porosity of the graphite used to construct the crucible 202. Preferable, the porosity of the thermally insulating unit 214 is 70% of the porosity of the porosity of graphite used to construct the crucible 202.

The beneficial effects of a thermally insulating unit 214 may be achieved by either providing an inserted thermally insulating unit before starting the growing process, or by using a temperature profile during the growth of the single crystal, which causes the formation of a suitably formed graphite foam on the inside of the crucible sidewall. In the latter case, the thermally insulating unit 214 is present only during a part of the whole growing process.

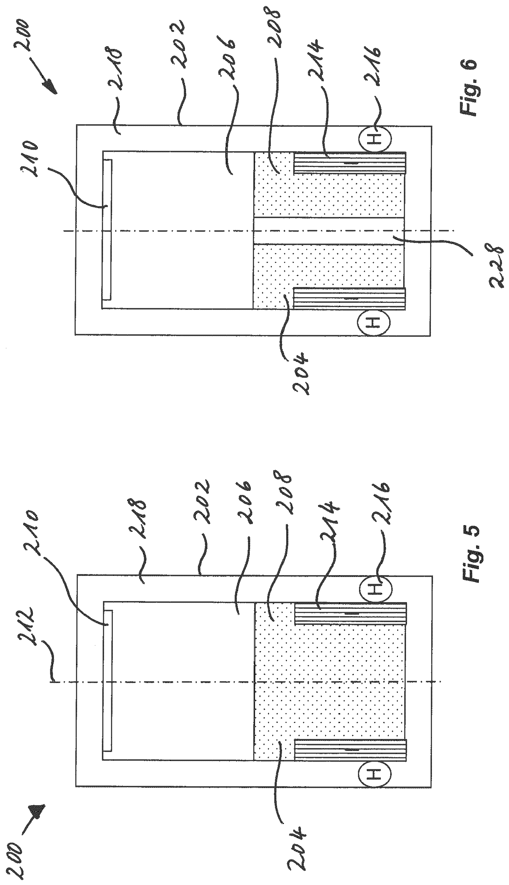

Fig. 5 shows another example of the system 200 in accordance with the present disclosure. The thermally insulating unit 218 is arranged to be directly adjacent to the bottom part of the source material compartment 204.

Fig. 6 illustrates a further example of the system 200 in accordance with the present disclosure. The system 200 comprises at least one pillar 228, which is arranged within the source material compartment 204. The pillar is adjacent to the bottom of the crucible 202 and is arranged along the central axis 212 of the crucible 202. The pillar 228 provides a heat flow by heat conduction into the center of the source material compartment 204.

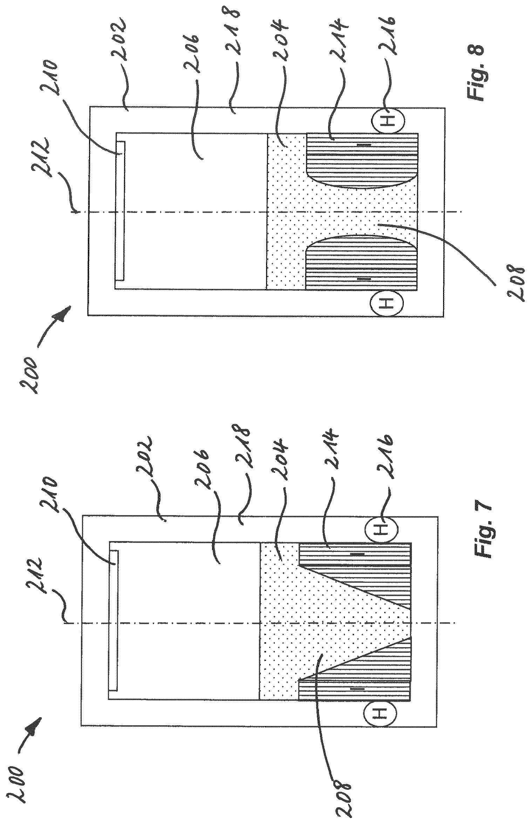

Fig. 7 and Fig. 8 show two examples of the system 200 in which the thermally insulating unit 214 has a particularly advantageous geometry. In Fig. 7, the thermally insulating unit 214 is formed so that its inner walls form a funnel within the source material compartment 204.

In Fig. 8, the thermally insulating unit 214 is formed so that its inner walls form a concave cylinder within the source material compartment 204.

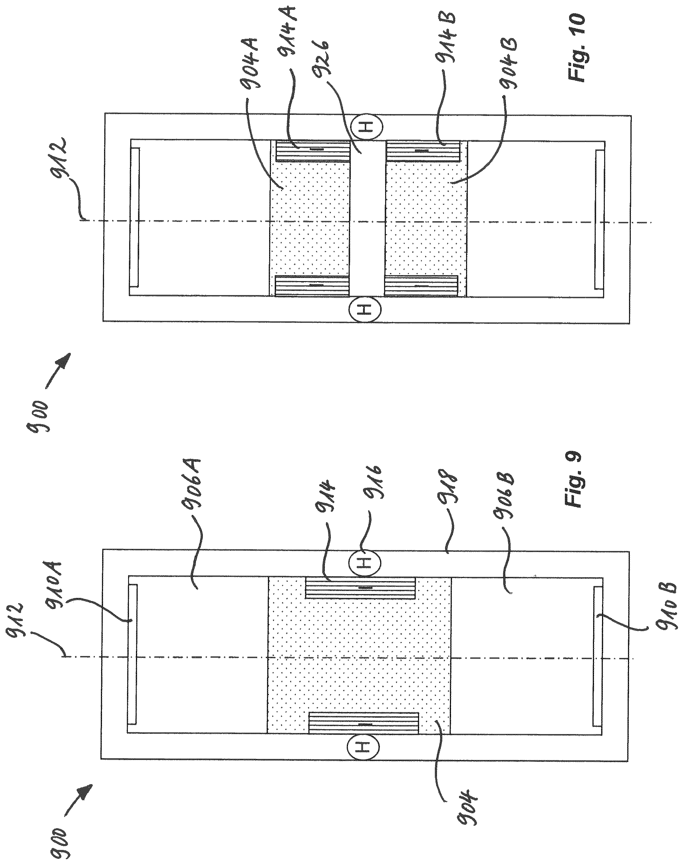

Fig. 9 to Fig. 12 show advantageous examples in which the sublimation system 900 encompasses two growth areas 906A and 906B.

In Fig. 9, the sublimation system 900 comprises a single source material compartment 904. A single heating system (not shown in Fig. 9) is installed forming one area with high temperature 916 within the sidewall of the crucible 918. This area with high temperature 916 forms a ring around the source material compartment 904. A thermally insulating unit 914 forms a ring within the source material compartment 904 adjacent to the area with high temperature 916.

Fig. 10 shows a sublimation system 900 with two growth areas 906A and 906B. This system additionally comprises a barrier 926, which divides the source material compartment 904 into two separate source material compartments 904A and 904B. A single heating system (not shown in Fig. 10) is installed forming one area with higher temperature 916 within the sidewall of the crucible 918 adjacent to the barrier 926. This area with high temperature 916 forms a ring within the source material compartment 904. Two thermally insulating units 914A and 914B are arranged within source material compartments 904A and 904B, respectively. Both thermally insulating units 914A and 914B form a ring within the respective source material compartment 904A and 904B in the area closest to the area with high temperature 916.

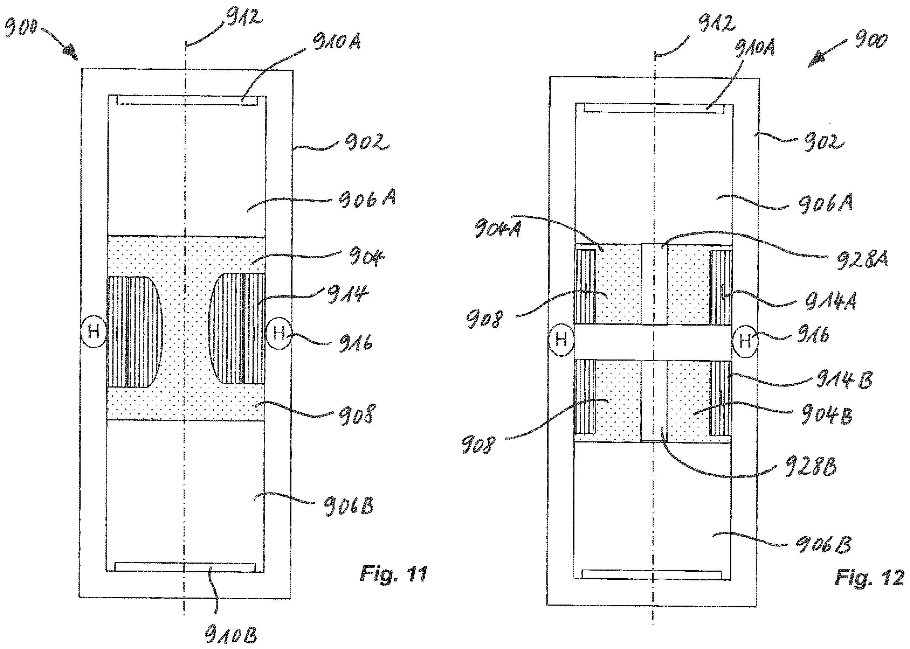

Fig. 11 shows a sublimation system 900 with two growth areas 906A and 906B. The system 900 comprises a single source material compartment 904 as already described in Fig. 9. The thermally insulating unit 914 is arranged so that its inner wall forms a concave cylinder.

Fig. 12 shows a sublimation system 900 with two growth areas 906A and 906B. The system comprises two separate source material compartments 904A and 904B as already describe in connection with Fig. 10. Additionally, the sublimation system 900 may comprise at least two pillars 928A and 928B, which are arranged within the source material compartments 904A and 904B in a similar manner as disclosed in Fig. 6. Again, the pillars 928A, 928B provide a heat flow by heat conduction into the center of the source material compartments 904A, 904B.

REFERENCE NUMERALS

| Reference Numeral | Description |
| --- | --- |
| 100 | sublimation system; PVT system |
| 102 | crucible |
| 104 | SiC supply region; source material compartment |
| 106 | crystal growth region |
| 108 | source material |
| 110 | seed crystal |
| 112 | central axis |
| 116 | areas with high temperature |
| 118 | sidewall of crucible |
| 120 | axial heat flow |
| 122 | radial heat flow |
| 124 A-N | isotherms |

(continued)

| Reference Numeral | Description |
| --- | --- |
| 200 | sublimation system; PVT system |
| 202 | crucible |
| 204 | SiC supply region; source material compartment |
| 206 | crystal growth region |
| 208 | source material |
| 210 | seed crystal |
| 212 | central axis |
| 214 | thermally insulating unit |
| 216 | area with high temperature |
| 218 | sidewall of crucible |
| 220 | axial heat flow |
| 222 | radial heat flow |
| 224 A-N | isotherms |
| 228 | pillar |
| 900 | sublimation system; PVT system |
| 902 | crucible |
| 904, 904A, 904B | SiC supply region; source material compartment |
| 906A, 906B | crystal growth region |
| 908 | source material |
| 910A, 910B | seed crystal |
| 912 | central axis |
| 914, 914A, 914B | thermally insulating unit |
| 916 | area with high temperature |
| 918 | sidewall of crucible |
| 926 | barrier |
| 928A, 928B | pillar |
| 1300 | PVT system |
| 1302 | crucible |
| 1304 | SiC supply region |
| 1306 | crystal growth region |
| 1308 | source material |
| 1310 | seed crystal |
| 1312 | crucible lid |
| 1314 | container; reactor |
| 1316 | inductive heating coil |

**Claims**

1. Sublimation system (200) for growing at least one single crystal of semiconductor material by means of a sublimation growing process, the sublimation system (200) comprising:

   a crucible (202) having a longitudinal axis (212) and a sidewall (218) extending along the longitudinal axis (212), wherein the crucible (202) comprises a fixing means for at least one seed crystal (210) and at least one source material compartment (204) for containing a source material (208); and
   a heating system for generating a temperature field around a circumference of the crucible (202) along the longitudinal axis (212) of the crucible (202);
   a thermally insulating unit (214) arranged within the source material compartment (204) at the sidewall (218) of the crucible (202).

2. The system of claim 1, wherein the thermally insulating material is arranged adjacent to an area in which during operation the temperature is higher than at the remaining part of the sidewall (218) of the source material compartment (204).

3. The system of claim 1 or 2, wherein the system further comprises an outer insulation unit, which surrounds the crucible (202).

4. The system of claim 1 to 3, wherein at least one pillar is arranged along the longitudinal axis (212) within the source material compartment (204).

5. The system of claim 1 to 4, wherein the source material compartment (204) is divided into two separate compartments by a barrier which extends across the longitudinal axis (212); and
   wherein the crucible (202) comprises a fixing means for at least two seed crystal (210).

6. The system of claim 5, wherein the heating system is arranged so that during operation the temperature at the barrier extending across the longitudinal axis (212) is higher than at the remaining part of the sidewall (218)s of the source material compartment (204).

7. The system of one of claim 1 to 6, wherein a thermal conductivity of the thermally insulating unit (214) is lower than a thermal conductivity of the source material (208) and/or a thermal conductivity of a material of the sidewall (218).

8. The system of one of claim 1 to 7, wherein the porosity of the thermally insulating unit (214) is higher than the porosity of the source material (208) and/or the porosity of a material of the outer insulation unit.

9. The system of one of claim 1 to 8, wherein a volume of the thermally insulating unit (214) is between 10% and 50% of a volume of the crucible (202), preferably the volume of the thermally insulating unit (214) is 35% of the volume of the crucible (202).

10. The system of one of claim 1 to 9, wherein the thermal conductivity of the thermally insulating unit (214) is at least 20% smaller than a thermal conductivity of a material of the crucible (202).

11. The system of one of claim 1 to 10, wherein the porosity of the thermally insulating unit (214) is between 50% and 90% of a porosity of graphite used to construct the crucible (202), preferably the porosity of the thermally insulating unit (214) is 70% of the porosity of the graphite used to construct the crucible (202).

12. The system of claim 1 to 11, wherein the thermally insulating unit (214) comprises at least one of: porous graphite, graphite felt and graphite powder.

13. The system of claim 1 to 12, wherein the thermally insulating unit (214) forms a ring along the sidewall (218) of the crucible (202).

14. The system of claim 13, wherein an inner wall of the thermally insulating unit (214) forms a funnel shape; or wherein the inner wall of the thermally insulating unit (214) forms a concave cylinder.

15. Method of growing at least one single crystal of a semiconductor material by means of a sublimation growing process, the method comprising:

providing a crucible (202) having a longitudinal axis (212) and a sidewall (218) extending along the longitudinal axis (212), fixing at least one seed crystal (210) at a fixing means of the crucible (202), and filling a source material (208) into at least one source material compartment (204);

wherein, during at least a part of the growing process, a thermally insulating unit (214) is present within the source material compartment (204) at the sidewall (218) of the crucible (202);

generating, by means of a heating system, a temperature field around a circumference of the crucible (202) and along the longitudinal axis (212) of the crucible (202).

**Fig. 1**

**Fig. 2**

Fig. 4

Fig. 3

**Fig. 5**

**Fig. 6**

EP 4 431 644 A1

Fig. 8

Fig. 7

16

912

906A

910A

914

916

H

918

906B

910B

904

*Fig. 9*

900

912

904A

914A

926

H

H

914B

904B

*Fig. 10*

900

Fig. 11

Fig. 12

Fig. 13

Europäisches
Patentamt

European
Patent Office

Office européen
des brevets

# EUROPEAN SEARCH REPORT

Application Number

EP 23 16 1965

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2010/111473 A1 (II VI INC [US]; GUPTA AVINASH K [US] ET AL.) 30 September 2010 (2010-09-30) | 1-3,7,9, 12,13,15 | INV. C30B23/06 C30B29/36 |
| Y | * figure 8 * * example 2 * | 4-6,14 | |
| X | JP 2008 290903 A (DENSO CORP) 4 December 2008 (2008-12-04) | 1-3, 7-13,15 | |
| Y | * figure 3 * * paragraphs [0053] - [0064] * | 4 | |
| Y | JP 2021 084827 A (SHOWA DENKO KK) 3 June 2021 (2021-06-03) * figures 1-3 * * paragraphs [0035] - [0040] * | 4 | |
| Y | CN 113 293 438 A (ZHONGKE HUITONG INNER MONGOLIA INVEST HOLDINGS CO LTD) 24 August 2021 (2021-08-24) * figure 1 * | 5,6 | |
| Y | US 2020/224328 A1 (FUJIKAWA YOHEI [JP]) 16 July 2020 (2020-07-16) * figures 5, 6 * * pages 43-50 * | 14 | TECHNICAL FIELDS SEARCHED (IPC) C30B |

The present search report has been drawn up for all claims

| Place of search | Date of completion of the search | Examiner |
|---|---|---|
| The Hague | 21 July 2023 | Schmitt, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 431 644 A1**

## ANNEX TO THE EUROPEAN SEARCH REPORT
## ON EUROPEAN PATENT APPLICATION NO.

EP 23 16 1965

This annex lists the patent family members relating to the patent documents cited in the above-mentioned European search report.
The members are as contained in the European Patent Office EDP file on
The European Patent Office is in no way liable for these particulars which are merely given for the purpose of information.

21-07-2023

| Patent document cited in search report | | Publication date | Patent family member(s) | | Publication date |
|---|---|---|---|---|---|
| WO 2010111473 | A1 | 30-09-2010 | EP | 2411569 A1 | 01-02-2012 |
| | | | JP | 5779171 B2 | 16-09-2015 |
| | | | JP | 2012521948 A | 20-09-2012 |
| | | | US | 2012103249 A1 | 03-05-2012 |
| | | | US | 2019249332 A1 | 15-08-2019 |
| | | | US | 2022002906 A1 | 06-01-2022 |
| | | | WO | 2010111473 A1 | 30-09-2010 |
| JP 2008290903 | A | 04-12-2008 | JP | 4941099 B2 | 30-05-2012 |
| | | | JP | 2008290903 A | 04-12-2008 |
| JP 2021084827 | A | 03-06-2021 | NONE | | |
| CN 113293438 | A | 24-08-2021 | NONE | | |
| US 2020224328 | A1 | 16-07-2020 | CN | 111424311 A | 17-07-2020 |
| | | | JP | 7286970 B2 | 06-06-2023 |
| | | | JP | 2020111481 A | 27-07-2020 |
| | | | US | 2020224328 A1 | 16-07-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8865324 B2
- US 20160138185 A1
- US 20170321345 A1
- CN 210974929 U
- JP 6859800 B
- JP 6501494 B